# FASCICULE DE BREVET EUROPEEN

(11) **EP 2 786 498 B1**
(45) Date de publication et mention de la délivrance du brevet: **17.01.2018**
(21) Numéro de dépôt: 12795409.7
(22) Date de dépôt: 28.11.2012
(51) Int. Cl.: H03M 13/29, H03M 13/37, H03M 13/39

(54) **DECODEUR DE FAIBLE COMPLEXITE POUR CODAGE CONVOLUTIF**
DEKODIERER MIT GERINGER KOMPLEXITÄT FÜR FALTUNGSKODIERUNG
LOW-COMPLEXITY DECODER FOR CONVOLUTIONAL ENCODING

(30) Priorité: 29.11.2011 FR 1160925
(43) Date de publication de la demande: 08.10.2014
(73) Titulaire: Safran Electronics & Defense, 92100 Boulogne-Billancourt (FR)
(72) Inventeur: CHIODINI, Alain, 92100 Boulogne-Billancourt (FR); GILLET, Michel, 92100 Boulogne-Billancourt (FR)
(74) Mandataire: Regimbeau
(86) Numéro de dépôt international: PCT/EP2012/073853
(87) Numéro de publication internationale: WO 2013/079540

(56) Documents cités:
- FR-A1- 2 765 749
- US-A1- 2011 209 029

## Description

### DOMAINE DE L'INVENTION

Le domaine de l'invention est celui des codes détecteurs et correcteurs d'erreurs, et plus précisément celui des codes dits convolutifs. Dans ce cadre, l'invention concerne un décodeur de faible complexité pour codes convolutifs.

### ARRIERE PLAN DE L'INVENTION

Les codes convolutifs forment une classe souple et efficace de codes détecteurs et correcteurs d'erreurs. II s'agit des codes les plus utilisés actuellement dans les systèmes de communications fixes et mobiles. Le terme « convolutif » traduit le fait que la suite de bits codés est le résultat de la convolution de la suite de bits d'information par les coefficients d'au moins deux séquences binaires fixes appelées polynômes générateurs.

Le codage des données binaires à émettre est effectué à l'aide d'un codeur convolutionnel : la sortie de ce dispositif dépend de l'information courante à coder (instant n) ainsi que de l'information précédente (instants n-1, n-2, ..., n-K+1) et de l'état du codeur. Le paramètre K est appelé la longueur de contrainte du code et définit le nombre d'états du code convolutif (2^{K-1}). En pratique, un codeur convolutionnel est réalisé à l'aide d'un registre à décalage et de « OU exclusifs ».

La manière classique de décoder un code est de comparer la séquence reçue y(n) à toutes les séquences possibles x(n) susceptibles d'être émises et de choisir la plus vraisemblable parmi elles. Cette manière de procéder présente une complexité exponentielle (croissante avec la taille de la séquence reçue) et n'est par conséquent pas réalisable en pratique. La réduction de l'écart entre le message observé et le message décodé est effectuée selon le critère du maximum de vraisemblance. La méthode de décodage la plus répandue actuellement, et notamment intégrée dans bon nombre de produits de masse (GSM, WiFi, etc.), est basée sur l'algorithme de Viterbi (il s'agit d'un algorithme de programmation dynamique qui prend en compte la structure répétitive du treillis généré à partir des polynômes générateurs du code convolutif utilisé). II permet à la réception d'un mot y de déterminer le mot de code x le plus proche (selon le critère du maximum de vraisemblance). Le décodage à maximum de vraisemblance consiste à chercher dans le treillis du code le chemin le plus proche de la séquence reçue.

Un inconvénient du décodeur de Viterbi est que sa complexité est élevée et peut ne pas être compatible avec les ressources logicielles du récepteur devant mettre en oeuvre le décodage. Cette complexité se traduit également par une consommation d'énergie électrique qui peut s'avérer trop importante vis-à-vis des ressources de certains récepteurs (appareils portables en particulier).

II existe donc un besoin pour une solution de décodage de codes convolutifs dont la complexité serait très faible par rapport à celles reposant sur l'algorithme de Viterbi.

II est en outre à noter qu'en pratique le décodeur de Viterbi ne peut réaliser le décodage de codes convolutifs ayant une longueur de contrainte supérieure à 7 car sa complexité s'accroîtrait alors au point de devenir prohibitive. On comprend donc que le pouvoir de correction (ou gain de codage) est en réalité limité.

US2011/0209029 décrit un système de correction d'erreur dans lequel deux suites binaires sont comparées, et une suite binaire de détection (XOR stream) est formée.

### EXPOSÉ DE L'INVENTION

L'invention a pour objectif de proposer un décodeur de code convolutif de faible complexité et propose à cet effet selon un premier aspect un procédé pour la correction d'erreurs de transmission dans lequel au moins deux suites binaires codées correspondent chacune au résultat de la convolution d'une même suite binaire à transmettre avec les coefficients d'un polynôme générateur respectif et sont reçues depuis un canal de communication, caractérisé en ce qu'il comporte les étapes consistant à :
- produire, à partir de deux suites binaires codées reçues, des suites binaires de comparaison qui coïncident en l'absence d'erreurs de transmission sur le canal de communication ;
- comparer les suites binaires de comparaison et former une suite binaire de détection correspondant à l'opération logique OU-exclusif des deux suites binaires de comparaison;
- en cas de divergence des suites binaires de comparaison à partir d'un point de divergence, vérifier si la séquence constituée de P bits de la suite binaire de détection à partir du point de divergence correspond à une erreur de transmission répertoriée et corriger le cas échéant les suites binaires codées reçues.

L'invention concerne selon un second aspect un récepteur de données, caractérisé en ce qu'il comporte un décodeur de code convolutif comprenant une mémoire pour stocker des erreurs de transmission répertoriées et un processeur configuré pour mettre en oeuvre le procédé selon le premier aspect de l'invention.

L'invention s'étend également à un système de transmission de données comprenant un émetteur et un récepteur selon le second aspect de l'invention.

### BREVE DESCRIPTION DES DESSINS

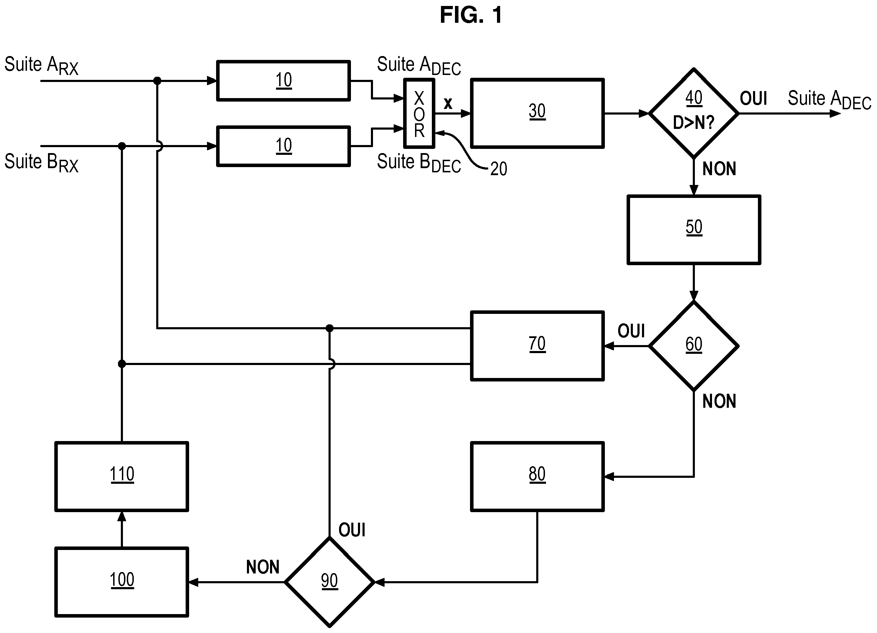

D'autres aspects, buts et avantages de la présente invention apparaîtront mieux à la lecture de la description détaillée suivante de formes de réalisation préférées de celle-ci, donnée à titre d'exemple non limitatif, et faite en référence à l'unique figure 1 annexée qui représente un schéma de principe du décodeur objet de l'invention.

### DESCRIPTION DETAILLEE DE L'INVENTION

L'invention concerne selon son premier aspect un procédé pour la correction d'erreurs de transmission dans au moins deux suites binaires codées résultant du codage d'un message à transmettre par un code convolutif et transmises sur un canal de communication.

Chacune des suites binaires codées résulte préférentiellement du codage convolutif d'une même suite binaire « source » à transmettre exploitant deux polynômes générateurs. On obtient alors deux suites binaires codées qui correspondent ainsi chacune au résultat de la convolution d'une suite binaire « source » à transmettre avec les coefficients d'un polynôme générateur respectif, à savoir une première suite binaire résultant de la convolution de la suite binaire à transmettre avec un premier polynôme générateur et une seconde suite binaire résultant de la suite binaire à transmettre avec un second polynôme générateur différent du premier polynôme générateur.

A titre d'exemple purement illustratif, les suites binaires codées sont produites par un codeur implémentant le code convolutif exploitant les polynômes générateurs [133]₈ et [171]₈ (notation octale) sur une longueur de contrainte égale à 7. Les coefficients ces polynômes sont ainsi les suivants : [1011011]₂ et [1111001]₂.

On relèvera que l'invention n'est pas limitée par le nombre de polynômes générateurs exploités par le code convolutif utilisé. Ainsi, si le code convolutif utilisé comporte plus de deux polynômes générateurs et, par conséquent, produit plus de deux suites binaires, on peut alors se ramener au cas simple basé sur l'utilisation de deux suites binaires (cas préférentiellement décrit dans ce qui suit) en traitant par exemple, en parallèle ou successivement, tous les couples de suites binaires qu'il est possible de former avec le jeu de suites binaires produites par le code convolutif utilisé.

En référence à la figure 1, le procédé de correction d'erreurs débute par la réception depuis le canal de communication d'au moins deux suites binaires codées reçues A_{RX} et B_{RX} (ces deux suites sont extraites d'une même suite binaire « source » par désentrelacement).

Au cours d'une première étape représentée par le bloc 10 sur la figure 1, on produit, à partir des deux suites binaires codées reçues A_{RX}, B_{RX}, des suites binaires de comparaison A_{DEC}, B_{DEC} qui coïncident en l'absence d'erreurs de transmission sur le canal de communication.

Selon un premier mode de réalisation, on produit les suites binaires de comparaison A_{DEC}, B_{DEC} en réalisant la convolution de chacune des suites binaires codées reçues A_{RX}, B_{RX}, avec les coefficients du polynôme générateur ayant servi à coder l'autre suite binaire codée reçue. On note dans ce qui suit M la suite binaire à transmettre, P_{A}, respectivement P_{B}, le polynôme générateur correspondant à l'obtention de la suite codée A_{TX} (= M*P_{A}), respectivement B_{TX} (=M*P_{B}) transmise sur le canal de transmission depuis lequel elle est reçue sous la forme de la suite codée reçue A_{RX}, respectivement B_{RX}. Dans le cadre de ce premier mode de réalisation, on utilise le polynôme P_{B} pour la convolution de la suite A_{RX} et le polynôme P_{A} pour la convolution de la suite B_{RX}. En l'absence d'erreurs de transmission sur le canal (A_{TX} = A_{RX} et B_{TX} = B_{RX}), les suites binaires de comparaison sont identiques : A_{DEC}=A_{RX}*P_{B}=A_{TX}*P_{B}=M*P_{A}*P_{B} et B_{DEC}=B_{RX}*P_{A}=B_{TX}*P_{A}=M*P_{B}*P_{A}.

Selon un second mode de réalisation, on produit les suites binaires de comparaison A_{DEC}, B_{DEC} en réalisant la déconvolution de chacune des suites binaires codées reçues au moyen du polynôme générateur ayant servi à la coder à l'émission. En l'absence d'erreurs de transmission sur le canal, les suites binaires de comparaison sont identiques et correspondent à la suite à émettre: A_{DEC}=A_{RX}*1/P_{A}=A_{TX}*1/P_{A}=M*P_{A}*1/P_{A}=M et B_{DEC}=B_{RX}*1/P_{B}=B_{TX}*1/P_{B}=M*P_{B}*1/P_{B}=M.

On notera dès à présent que dans une variante de réalisation avantageuse de l'invention, ces deux modes de réalisation sont mis en oeuvre conjointement en produisant deux paires de suites binaires de comparaison.

Tel que représenté par le bloc 20, on vient ensuite comparer les suites binaires de comparaison A_{DEC}, B_{DEC} et former une suite binaire de détection X correspondant à l'opération logique OU-exclusif des deux suites binaires de comparaison.

En l'absence d'erreurs, les suites binaires de comparaison A_{DEC} et B_{DEC} doivent coïncider parfaitement. En présence d'erreurs, elles vont diverger à partir d'un certain point (point de divergence D) identifiable facilement grâce à la suite binaire de détection X. L'indice temporel associé à ce point permet de repérer précisément le début de la séquence d'erreurs. Le bloc 30 sur la figure 1 représente la détection d'un tel point de divergence, tandis que le bloc 40 illustre le fait que si D excède la longueur N de la séquence binaire à décoder alors on n'opère pas de correction et le décodage prend fin.

Tel que représenté par les blocs 50 et 60, on vient ensuite vérifier si la séquence constituée de P bits de la suite binaire de détection à partir du point de divergence correspond à une erreur de transmission répertoriée. On corrige le cas échéant (bloc 70) les suites binaires codées reçues.

On notera que P est par exemple égal à 2K-1 dans le cas du premier mode de réalisation, et par exemple égale à K dans le cas du premier mode de réalisation, K représentant la longueur de contraintes du code convolutif.

Selon un mode de réalisation, ladite séquence est utilisée pour calculer (bloc 50) une métrique correspondant par exemple au nombre entier constitué des bits consécutifs X(D) à X(D+P-1). Cette métrique permet d'identifier le cas échéant la séquence d'erreurs détectée (bloc 60 au cours duquel on vérifie si la métrique est connue). Ainsi dans le cadre de l'invention, un certain nombre d'erreurs triviales (simples, doubles, triples et quadruples) a été répertoriée, chacune associée à une valeur de la métrique. Dès lors, si la métrique ainsi calculée à partir de la séquence constituée des bits consécutifs X(D) à X(D+P-1) correspond à une erreur répertoriée, alors les suites binaires codées reçues sont corrigées (bloc 70).

Les valeurs de la métrique retenues pour la détection d'erreurs triviales peuvent être les suivantes (la liste ci-dessous n'est pas exhaustive) :

| Métrique | Séquences d'erreurs simples, doubles, triples et quadruples triviales détectées | | | | | | | | |
|---|---|---|---|---|---|---|---|---|---|
| | Indice | D-4 | D-3 | D-2 | D-1 | D | D+1 | D+2 | D+3 |
| 112 | Suite ARX | | | | | X | | | |
| | Suite BRX | | | | | | | | |
| 87 | Suite ARX | | | | | X | | | |
| | Suite BRX | | | | | | X | | |
| 99 | Suite ARX | | | | | X | | | |
| | Suite BRX | | | | | | | X | |
| 121 | Suite ARX | | | | | X | | | |
| | Suite BRX | | | | | | | | X |
| 78 | Suite ARX | | | | | | | | |
| | Suite BRX | | | | | X | | | |
| 118 | Suite ARX | | | | | | X | | |
| | Suite BRX | | | | | X | | | |
| 82 | Suite ARX | | | | | | | X | |
| | Suite BRX | | | | | X | | | |
| 64 | Suite ARX | | | | | | | | X |
| | Suite BRX | | | | | X | | | |
| 72 | Suite ARX | | | | | X | X | | |
| | Suite BRX | | | | | | | | |
| 105 | Suite ARX | | | | | | | | |
| | Suite BRX | | | | | X | X | | |
| 108 | Suite ARX | | | | | X | | X | |
| | Suite BRX | | | | | | | | |
| 93 | Suite ARX | | | | | | | | |
| | Suite BRX | | | | | X | | X | |
| 126 | Suite ARX | | | | | X | | | X |
| | Suite BRX | | | | | | | | |
| 71 | Suite ARX | | | | | | | | |
| | Suite BRX | | | | | X | | | X |
| 125 | Suite ARX | | | | X | | | | |
| | Suite BRX | | | | X | | | | |
| 111 | Suite ARX | | | | | X | X | | |
| | | | | | | | | | |
| | Suite BRX | | | | | | X | | |
| 81 | Suite ARX | | | | | | X | | |
| | Suite BRX | | | | | X | X | | |
| 103 | Suite ARX | | | X | | | | | |
| | Suite BRX | | | X | X | | | | |
| 67 | Suite ARX | | | | X | X | | | |
| | Suite BRX | | | | X | X | | | |
| 84 | Suite ARX | | | X | X | | | | |
| | Suite BRX | | | X | | X | | | |
| 94 | Suite ARX | X | | X | | | | | |
| | Suite BRX | X | X | | | | | | |
| 98 | Suite ARX | | | | X | | X | | |
| | Suite BRX | | | | X | | X | | |

Si au bloc 60 de la figure 1, la métrique ne correspond à aucune des erreurs répertoriées, on peut selon un mode de réalisation de l'invention mettre en oeuvre un décodage de Viterbi des suites binaires codées reçues.

De manière préférentielle, l'invention propose le mécanisme suivant lorsqu'au bloc 60 de la figure 1, la métrique ne correspond à aucune des erreurs répertoriées. II est tout d'abord fait l'hypothèse que seule l'une des suites binaires codées reçues (par exemple A_{RX}) est corrompue et on corrige alors (bloc 80) ce qui est supposée être une erreur, par exemple une erreur simple, dans cette suite binaires codée reçue pour former une suite corrigée (notée A'_{Rx} ci-après).

On cherche ensuite à valider cette correction. Pour cela on forme à partir de la suite corrigée A'_{RX} une nouvelle suite binaire de comparaison A'_{DEC} qui coïncide en l'absence d'erreurs de transmission sur le canal de communication avec la suite binaire de comparaison B_{DEC} formée à partir de la seconde suite binaire codée reçue. La nouvelle suite binaire de comparaison A'_{DEC} est obtenu de manière similaire à la suite binaire A_{DEC}, selon l'un des deux modes de réalisation décrits précédemment.

La correction apportée à la suite A_{RX} est validée (bloc 90) si la divergence entre la nouvelle suite binaire de comparaison A'_{DEC} et la suite binaire de comparaison B_{DEC} formée à partir de la seconde suite binaire codée reçue apparaît plus tardivement que la divergence préalablement détectée entre les deux suites binaires de comparaison A_{DEC} et B_{DEC}. Ainsi si l'indice temporel associé au nouveau point de divergence dépasse le précédent point de divergence d'au moins une unité alors la correction est validée, et le procédé de correction d'erreurs se poursuit.

Sinon, la correction sur A_{RX} est annulée (bloc 100), et on suppose que la suite B_{RX} est corrompue. On corrige alors (bloc 110) ce qui est supposée être une erreur sur cette suite B_{RX} et le procédé de correction d'erreurs se poursuit.

De manière préférentielle, le procédé de correction d'erreurs prend fin lorsque le nombre d'erreurs corrigées excède une limite donnée.

On a décrit précédemment deux modes de réalisation des suites binaires de comparaison A_{DEC} et B_{DEC} Dans une variante de réalisation avantageuse de l'invention, ces deux modes de réalisation sont mis en oeuvre conjointement en produisant deux paires de suites binaires de comparaison. On forme ensuite deux suites binaires de détection, chacune à partir de la comparaison des suites binaires de comparaison de l'une des paires et on calcule alors deux métriques m1 (correspondant à la mise en oeuvre du premier mode de réalisation) et m2 (correspondant à la mise en oeuvre du second mode de réalisation) en présence d'erreurs de transmission. Une métrique pouvant correspondre à plusieurs profils d'erreurs de transmission, le fait de disposer de deux métriques de discriminer un unique profil d'erreur de transmission en levant avec une seconde métrique l'ambiguïté résultant d'une première métrique. On peut de la sorte corriger un nombre d'erreurs plus important.

On comprend donc que l'invention porte sur l'utilisation de l'une ou l'autre métrique seule, et préférentiellement sur l'utilisation des deux métriques ensemble, la métrique m2 servant à lever une ambigüité relevée par la métrique m1 ou vice-versa.

Les performances du décodeur objet de l'invention sont proches de celles du décodeur de Viterbi dans le cas de l'utilisation de décisions dures en sortie du démodulateur côté récepteur. Toutefois, la complexité du décodeur selon l'invention est très faible comparée à celle du décodeur de Viterbi de sorte qu'un tel décodeur peut être implémenté malgré des ressources logicielles limitées. Le décodeur selon l'invention représente donc une alternative avantageuse au décodeur de Viterbi, permettant de réduire significativement la surface de silicium, le nombre d'opérations et la consommation d'énergie électrique nécessaires à l'implémentation et au fonctionnement d'un décodeur de codes convolutifs. Cette alternative s'avère également avantageuse en ce qu'elle permet le décodage de codes convolutifs ayant une longueur de contrainte supérieure à 7 (ce que ne peut faire en pratique le décodeur de Viterbi du fait de sa complexité qui serait alors prohibitive) et donc de réaliser des gains de codage importants.

Une application que l'on pourra faire de l'invention concerne les communications mettant en oeuvre une compression audio selon le codec G.726 par exemple, notamment dans le cadre de communications reposant sur la norme de téléphonie sans fil DECT (en anglais, « *Digital European Cordless Telephone* »). Le débit binaire du codec G.726 peut être de 16, 24, 32 ou 40 kbits/s. L'invention propose de configurer le codec à un débit binaire inférieur au débit maximal (par exemple à 16 kbits/s dans des applications où il est normalement utilisé à 32 kbits/s) et d'exploiter l'espace binaire (16 kbits/s) ainsi libérée pour faire du codage de canal.

On aura compris que l'invention n'est pas limitée au procédé de correction d'erreurs de transmission selon son premier aspect, mais s'étend également à un récepteur de données incorporant un décodeur de code convolutif comprenant une mémoire pour stocker des erreurs de transmission répertoriées et un processeur configuré pour mettre en oeuvre le procédé selon le premier aspect de l'invention. L'invention s'étend également à un système de transmission de données comprenant un émetteur et un récepteur incorporant un décodeur de code convolutif conforme à l'invention. L'émetteur peut notamment incorporé un codeur configuré pour mettre en oeuvre une compression de données de voix selon un codec à un débit binaire inférieur au débit binaire maximal dudit codec et pour mettre en oeuvre un codage convolutif des données de voix ainsi compressées exploitant l'espace binaire libéré de par l'utilisation dudit débit binaire inférieur.

## Revendications

1. Procédé pour la correction d'erreurs de transmission dans lequel au moins deux suites binaires codées correspondent chacune au résultat de la convolution d'une même suite binaire à transmettre avec les coefficients d'un polynôme générateur respectif et sont reçues depuis un canal de communication, **caractérisé en ce qu'**une première suite binaire résulte de la convolution de la suite binaire à transmettre avec un premier polynôme générateur et une seconde suite binaire résulte de la convolution de la suite binaire à transmettre avec un second polynôme générateur différent du premier polynôme générateur, et ce qu'il comporte les étapes consistant à :
- produire, à partir de deux suites binaires codées reçues, des suites binaires de comparaison qui coïncident en l'absence d'erreurs de transmission sur le canal de communication ;
- comparer les suites binaires de comparaison et former une suite binaire de détection correspondant à l'opération logique OU-exclusif des deux suites binaires de comparaison;
- en cas de divergence des suites binaires de comparaison à partir d'un point de divergence, vérifier si la séquence constituée de P bits de la suite binaire de détection à partir du point de divergence correspond à une erreur de transmission répertoriée et corriger le cas échéant les suites binaires codées reçues.

2. Procédé selon la revendication 1, dans lequel pour produire les suites binaires de comparaison, on réalise la convolution de chacune des suites binaires codées reçues avec les coefficients du polynôme générateur ayant servi à coder l'autre suite binaire codée reçue.

3. Procédé selon la revendication 1, dans lequel pour produire les suites binaires de comparaison, on réalise la déconvolution de chacune des suites binaires codées reçues au moyen du polynôme générateur ayant servi à la coder.

4. Procédé selon l'une des revendications précédentes, dans lequel on n'opère pas de correction si le point de divergence correspond à une position qui excède la longueur de la séquence binaire à décoder.

5. Procédé selon l'une des revendications 1 à 4, dans lequel si la séquence constituée de P bits de la suite de détection à partir du point de divergence ne correspond pas à une erreur de transmission répertoriée, on met en oeuvre les étapes consistant à :
- corriger une erreur dans une première des suites binaires codées reçues pour former une suite corrigée ;
- former à partir de la suite corrigée une nouvelle suite binaire de comparaison qui coïncide en l'absence d'erreurs de transmission sur le canal de communication avec la suite binaire de comparaison formée à partir de la seconde suite binaire codée reçue ;
- valider la correction apportée à la première des suites binaires codées reçues si la divergence entre la nouvelle suite binaire de comparaison et la suite binaire de comparaison formée à partir de la seconde suite binaire codée reçue apparaît plus tardivement que la divergence préalablement détectée entre les deux suites binaires de comparaison formées à partir de la première et de la seconde suites binaires codées reçues.

6. Procédé selon la revendication 5, dans lequel si la correction apportée à la première des suites binaires codées reçues n'est pas validée, on corrige une erreur dans la seconde des suites binaires codées reçues.

7. Procédé selon l'une des revendications précédentes, **caractérisé en ce qu'**il prend fin lorsque le nombre d'erreurs corrigées excède une limite donnée.

8. Procédé selon l'une des revendications précédentes, dans lequel on forme une première suite binaire de détection à partir des suites binaires de comparaison produites conformément au procédé de la revendication 2 et une seconde suite binaire de détection à partir des suites binaires de comparaison produites conformément au procédé de la revendication 3, et dans lequel si on identifie plusieurs erreurs répertoriées à l'aide de la première ou de la seconde suite binaire de détection, on réalise une discrimination parmi ces erreurs répertoriées en vérifiant si l'une et/ou l'autre de ces erreurs ont également été identifiées à l'aide de l'autre suite binaire de détection.

9. Récepteur de données, **caractérisé en ce qu'**il comporte un décodeur de code convolutif comprenant une mémoire pour stocker des erreurs de transmission répertoriées et un processeur configuré pour mettre en oeuvre le procédé selon l'une des revendications précédentes.

10. Système de transmission de données comprenant un émetteur et un récepteur selon la revendication précédente.

11. Système de transmission de données selon la revendication précédente, dans lequel l'émetteur comprend un codeur configuré pour mettre en oeuvre une compression de données de voix selon un codec à un débit binaire inférieur au débit binaire maximal dudit codec et pour mettre en oeuvre un codage convolutif des données de voix ainsi compressées exploitant l'espace binaire libéré de par l'utilisation dudit débit binaire inférieur.

## Patentansprüche

1. Verfahren für die Korrektur von Übertragungsfehlern, wobei mindestens zwei codierte binäre Folgen jeweils dem Ergebnis der Faltung einer selben binären, mit den Koeffizienten eines jeweiligen Generator-Polynoms zu übertragenden Folge entsprechen und über einen Kommunikationskanal erhalten werden, **dadurch gekennzeichnet, dass** eine erste binäre Folge aus der Faltung der mit einem ersten Generator-Polynom zu übertragenden binären Folge resultiert und eine zweite binäre Folge aus der Faltung der mit einem zweiten Generator-Polynom, das sich vom ersten Generator-Polynom unterscheidet, zu übertragenden binären Folge resultiert, und dass es die folgenden Schritte umfasst:
- Produzieren, ausgehend von zwei empfangenen codierten binären Folgen, der binären Vergleichsfolgen, die bei Abwesenheit von Übertragungsfehlern auf dem Kommunikationskanal übereinstimmen;
- Vergleichen der binären Vergleichsfolgen und Bilden einer binären Detektionsfolge, die der logischen Operation exklusives ODER der zwei binären Vergleichsfolgen entspricht;
- bei Divergenz der binären Vergleichsfolgen ausgehend von einem Divergenzpunkt, Überprüfen, ob die Sequenz, die von P Bits der binären Detektionsfolge ausgehend vom Divergenzpunkt gebildet ist, einem katalogisierten Übertragungsfehler entspricht und gegebenenfalls Korrigieren der erhaltenen codierten binären Folgen.

2. Verfahren nach Anspruch 1, wobei, um die binären Vergleichsfolgen zu produzieren, die Faltung jeder der erhaltenen codierten binären Folgen mit den Koeffizienten des Generator-Polynoms durchgeführt wird, das zur Codierung der anderen erhaltenen codierten binären Folge gedient hatte.

3. Verfahren nach Anspruch 1, wobei, um die binären Vergleichsfolgen zu produzieren, die Entfaltung jeder der erhaltenen codierten binären Folgen mit dem Generator-Polynom durchgeführt wird, das zu deren Codierung gedient hatte.

4. Verfahren nach einem der vorangehenden Ansprüche, wobei keine Korrektur durchgeführt wird, wenn der Divergenzpunkt einer Position entspricht, die die Länge der zu decodierenden binären Sequenz überschreitet.

5. Verfahren nach einem der Ansprüche 1 bis 4, wobei, wenn die Sequenz, die von P Bits der Detektionsfolge ausgehend vom Divergenzpunkt gebildet ist, keinem katalogisierten Übertragungsfehler entspricht, die folgenden Schritte durchgeführt werden:
- Korrigieren eines Fehlers in einer ersten der empfangenen codierten binären Folgen, um eine korrigierte Folge zu bilden;
- Bilden, ausgehend von der korrigierten Folge, einer neuen binären Vergleichsfolge, die bei Abwesenheit eines Übertragungsfehlers auf dem Kommunikationskanal mit der binären Vergleichsfolge übereinstimmt, die ausgehend von der zweiten erhaltenen codierten binären Folge gebildet wurde;
- Validieren der Korrektur der erste der empfangenen codierten binären Folgen, wenn die Divergenz zwischen der neuen binären Vergleichsfolge und der ausgehend von der zweiten empfangenen codierten binären Folge gebildeten binären Vergleichsfolge später erscheint als die zuvor zwischen den zwei binären Vergleichsfolgen, die ausgehend von der ersten und der zweiten empfangenen codierten binären Folgen gebildet wurden, detektierte Divergenz.

6. Verfahren nach Anspruch 5, wobei, wenn die Korrektur der ersten der empfangenen codierten binären Folgen nicht validiert wird, die Korrektur eines Fehlers in der zweiten der empfangenen codierten binären Folgen erfolgt.

7. Verfahren nach einem der vorangehenden Ansprüche, **dadurch gekennzeichnet, dass** es beendet ist, wenn die Anzahl der korrigierten Fehler eine bestimmte Grenze überschreitet.

8. Verfahren nach einem der vorangehenden Ansprüche, wobei eine erste binäre Detektionsfolge ausgehend von gemäß dem Verfahren nach Anspruch 2 produzierten binären Vergleichsfolgen und eine zweite binäre Detektionsfolge ausgehend von gemäß dem Verfahren nach Anspruch 3 produzierten binären Vergleichsfolgen gebildet wird, und wobei, wenn mehrere katalogisierte Fehler mit Hilfe der ersten oder der zweiten binären Detektionsfolge identifiziert werden, eine Diskriminierung zwischen diesen katalogisierten Fehlern durch Überprüfen, ob der eine und/oder der andere dieser Fehler ebenfalls mit Hilfe der anderen binären Detektionsfolge identifiziert wurde, durchgeführt wird.

9. Datenempfänger, **dadurch gekennzeichnet, dass** er einen Faltungscode Dekodierer aufweist, umfassend einen Speicher zum Speichern der katalogisierten Übertragungsfehler, und einen Prozessor, der konfiguriert ist, um das Verfahren nach einem der vorangehenden Ansprüche durchzuführen.

10. Datenübertragungssystem, umfassend einen Sender und einen Empfänger nach vorangehendem Anspruch.

11. Datenübertragungssystem nach vorangehendem Anspruch, wobei der Sender einen Codierer umfasst, der konfiguriert ist, um eine Kompression von Stimmdaten gemäß einem Codec mit einer binären Geschwindigkeit durchzuführen, die kleiner als die maximale binäre Geschwindigkeit des Codec ist, und um eine Faltungscodierung der derart komprimierten Stimmdaten durchzuführen, die den durch die Verwendung der kleineren binären Geschwindigkeit freigewordenen binären Platz nutzt.

## Claims

1. A method for correction of transmission errors wherein at least two encoded binary series each correspond to the result of the convolution of the same binary series to be transmitted with the coefficients of a respective generator polynomial and are received from a communications channel, **characterised in that** a first binary series results from the convolution of the binary series to be transmitted with a first generator polynomial and a second binary series results from the convolution of the binary series to be transmitted with a second generator polynomial different of the first generator polynomial, and **in that** it comprises the steps consisting of:
- producing, from two received encoded binary series, comparison binary series which coincide in the absence of transmission errors over the communications channel;
- comparing the comparison binary series and forming a detection binary series corresponding to the logic operation exclusive OR (XOR) of the two comparison binary series;
- in case of divergence of the comparison binary series from a divergence point, verifying if the sequence constituted by P bits of the detection binary series from the divergence point corresponds to a listed transmission error and if needed correcting the received encoded binary series.

2. The method according to claim 1, wherein to produce the comparison binary series, the convolution of each of the received encoded binary series is carried out with the coefficients of the generator polynomial having served to encode the other received encoded binary series.

3. The method according to claim 1, wherein to produce the comparison binary series, the deconvolution of each of the received encoded binary series is carried out by means of the generator polynomial having served to encode it.

4. The method according to one of the preceding claims, wherein no correction is made if the divergence point corresponds to a position exceeding the length of the binary sequence to be decoded.

5. The method according to one of claims 1 to 4, wherein if the sequence constituted by P bits of the detection series from the divergence point does not correspond to a listed transmission error, the steps are carried out, consisting of:
- correcting an error in a first of the received encoded binary series to form a corrected series;
- forming from the corrected series a new comparison binary series which in the absence of transmission errors over the communications channel coincides with the comparison binary series formed from the second received encoded binary series;
- validating the correction made to the first of the received encoded binary series if the divergence between the new comparison binary series and the comparison binary series formed from the second received encoded binary series appears later than the divergence previously detected between the two comparison binary series formed from the first and the second received encoded binary series.

6. The method according to claim 5, wherein if the correction made to the first of the received encoded binary series is not validated, an error in the second of the received encoded binary series is corrected.

7. The method according to one of the preceding claims, **characterised in that** it ends when the number of corrected errors exceeds a given limit.

8. The method according to one of the preceding claims, wherein a first detection binary series is formed from comparison binary series produced in accordance with the method of claim 2 and a second detection binary series from comparison binary series produced in accordance with the method of claim 3, and wherein if several listed errors are identified by means of the first or second detection binary series, discrimination is made among these listed errors by verifying whether one and/or the other of these errors has also been identified by means of the other detection binary series.

9. A data receiver, **characterised in that** it comprises a convolutional code decoder comprising a memory for storing listed transmission errors and a processor configured to conduct the method according to one of the preceding claims.

10. A data transmission system comprising a transmitter and a receiver according to the preceding claim.

11. The data transmission system according to the preceding claim, wherein the transmitter comprises a coder configured to execute voice data compression according to a codec at a bit rate lower than the maximal bit rate of said codec and to execute convolutional coding of now compressed voice data exploiting the binary space freed by the use of said low bit rate.
